# EUROPEAN PATENT APPLICATION

(11) **EP 2 645 445 A1**
(43) Date of publication of application: **02.10.2013**
(21) Application number: 10859955.6
(22) Date of filing: 26.11.2010
(51) Int. Cl.: H01L 51/54, H01L 51/56

(54) **ORGANIC ELECTROLUMINESCENT DEVICE AND FABRICATION METHOD THEREOF**

(71) Applicant: Ocean's King Lighting Science&Technology Co., Ltd., Guangdong 518054 (CN)
(72) Inventor: WANG, Ping, Shenzhen Guangdong 518054 (CN); HUANG, Hui, Shenzhen Guangdong 518054 (CN); CHEN, Jixing, Shenzhen Guangdong 518054 (CN); ZHOU, Mingjie, Shenzhen, Guangdong 518054 (CN)
(74) Representative: Zenz
(86) International application number: PCT/CN2010/079203
(87) International publication number: WO 2012/068744

(57) **Abstract**

An organic electroluminescent device (OELD) and the fabrication method thereof are disclosed. The OELD comprises an anode(1), a cathode(2) opposite to the anode(1) and a light emission structure(3) between the anode(1) and the cathode(2).The OELD also comprises an insulation layer(4) between the anode(1) and the light emission structure(3) and the insulation layer(4) is attached to the anode(1).The material of the insulation layer(4) is a lithium salt compound and the thickness of the insulation layer(4) is 0.5-5nm.The insulation layer is arranged on the anode(1) to block the velocity of holes injecting into the light emission structure(3) from the anode, thereby ensuring the consistency in the amount of holes and electrons of the light emission structure(3), highly increasing the recombination probability of electrons and holes and reducing the influence of excess holes to the emission property of the device. Therefore the emission property of the device is highly improved.

## Description

### Technical Field

The present invention relates to an electroluminescent device, in particular, to an organic electroluminescent device and the fabrication method thereof.

### Background

The emission principle of OLED is that under applied electric field, the electrons are injected from the cathode to the lowest unoccupied molecular orbital (LUMO) of the organic compound, meanwhile the holes are injected from the anode to the highest occupied molecular orbital (HOMO) of the organic compound. An electron and a hole meet with each other in the light emitting layer, and recombine to form an exciton, then the exciton migrates under the applied electric field, transfering energy to the light emitting material, then the electron is excited thereby and jumps from the ground state to the excited state. The excited state electron loses energy and becomes enactive by radiation and emits a photon, and releases light energy.

The transport velocity of the holes is inconsistent with that of the electrons (the transport velocity of the holes is 10⁻³ -10⁻⁴ cm² V⁻¹ s⁻¹, and the transport velocity of the electrons is 10⁻⁵ -10⁻⁶ cm² V⁻¹ s⁻¹), as a result the recombination probability of the electrons and the holes is low, and the luminance and luminous efficiency of the device cannot be improved. In order to effectively improve the recombination probability of electrons and holes, it is necessary to improve the injection efficiency and the transport velocity of the electrons, balance the carriers, and control the recombination region, so as to obtain the desired luminous intensity and luminous efficiency. The injection efficiency of electrons are often improved by adding electron injection layer to the device, as a result the structure of such device not only ensures the good adhesion of the organic functional layer with the cathode, but also makes the injection of the electrons from the metal cathode into the organic functional film more easily.

However, the above-mentioned method can only improve the injection quantity of the electrons to a limited extent, and the transport velocity of the electrons is 1-2 orders of magnitude lower than that of the hole in the electron transport material, therefore the holes will still arrive at the light emitting layer prior to the electrons, and the amount of the holes arriving at the light emitting layer is larger than that of the electrons, thereby the holes accumulate at the interface between the light emitting layer and the functional layer, as a result a variety of events harmful to the light emission take place, e.g., the holes passing through the light emitting layer are quenched by the electrode, the recombination probability decreases because the amount of the holes is much larger than that of the electrons.

### SUMMARY

In view of this, an organic electroluminescent device is provided by the embodiment of the present invention, to solve the technical problems of low luminescent performance of the organic electroluminescent device caused by the amount of the holes being inconsistent with the amount of the electrons in the light emitting structure in the prior art.

The above-mentioned technical problem can be solved through the following technical solutions: an organic electroluminescent device, which comprises an anode, a cathode opposite to the anode and a light emitting structure between the anode and the cathode, and the organic electroluminescent device further comprises an insulating layer located between the anode and the light emitting structure and adhering to the anode, and the insulating layer is made of lithium salt compound and the thickness thereof is 0.5-5nm.

The embodiment of the present invention further provides a method for the fabrication of an organic electroluminescent device, comprising the following steps:

a conductive substrate being treated by lithography, after cleaning the conductive substrate being exposed to oxygen plasma or UV-ozone to obtain an anode, wherein the duration of the oxygen plasma treatment is 5-15 minutes, the power thereof is 10-50 watts; and the duration of the UV-ozone treatment is 5-20 minutes;

an insulating layer of lithium salt compound being arranged on the anode, wherein the insulating layer has a thickness of 0.5-5 nm;

a light emitting structure being prepared on the anode;

a cathode being arranged on the light emitting structure, to obtain an organic electroluminescent device.

The organic electroluminescent device according to the embodiment of the invention has an insulating layer prepared on the anode, which hinders the injection rate of the holes from the anode to the light emitting structure, reduces the number of holes injected from the anode into the light emitting structure, enhances the consistency of the number of the holes and that of the electrons in the light emitting structure, greatly improves the recombination probability of holes and electrons, decreases the influence of the excess holes on the luminescent performance of the device, and greatly increases the luminescent performance of the organic electroluminescent device. In the embodiment of the invention the fabrication method of the device is simple to operate, the cost is low, and it is suitable for industrial production.

### BRIEF DESCRIPTION OF THE DRAWINGS

Fig. 1 shows a structural schematic diagram of the organic electroluminescent device according to the example of the present invention.

Fig. 2 shows a structural schematic diagram of an organic electroluminescent device according to one example of the present invention.

Fig. 3 shows a structural schematic diagram of an organic electroluminescent device according to another example of the present invention.

Fig. 4 shows the rational graphs of current density and voltage of the organic electroluminescent devices according to the example and the comparative example of the present invention.

Fig. 5 shows a flow chart of the fabrication method of an organic electroluminescent device according to the example of the present invention.

### DETAILED DESCRIPTION OF THE PREFERRED EMBODIMENTS

Objects, embodiments and advantages of the present invention will be explained below in detail with reference to the accompanying drawings and embodiments. However, it should be appreciated that the following description of the embodiment is merely exemplary in nature and is not intended to limit this invention.

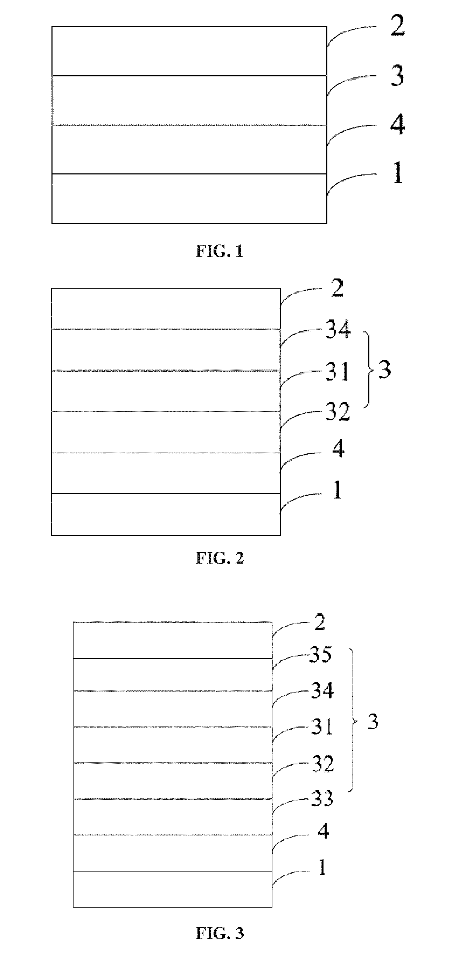

Referring to Fig. 1, which shows the structure of an organic electroluminescent device according the example of the present invention, wherein the organic electroluminescent device comprises an anode 1, a cathode 2 opposite to the anode 1 and a light emitting structure 3 arranged between the anode 1 and the cathode 2, and the organic electroluminescent device further comprises an insulating layer 4 disposed between the anode 1 and the light emitting structure 3 and adhering to the anode 1, and the insulating layer 4 is made of lithium salt compound and the thickness thereof is 0.5-5nm.

The organic electroluminescent device according to the example of the present invention has an insulating layer of lithium salt compound attached to the anode, wherein the insulating layer may hinder the injection of the holes generated from the anode to the light emitting structure, reduce the transport velocity of the holes, thereby decrease the number of holes transmitted to the light emitting structure, achieve the consistency of the number of the holes and that of the electrons in the light emitting structure, greatly improve the recombination probability of holes and electrons, effectively lower the influence of the holes being unrecombined with the electrons in the light emitting structure on the luminescent efficiency of the organic electroluminescent device, and greatly improve the luminescent efficiency of the organic electroluminescent device.

In particular, the light emitting structure 3 includes a light-emitting layer 31, a hole transport layer 32 and/or hole injection layer 33 arranged between the light emitting layer 31 and the insulating layer 4; wherein, when the hole transport layer 32 and the hole injection layer 33 exist simultaneously, the hole injection layer 33 will be disposed between the hole transport layer 32 and the insulating layer 4.

Additionally, the light emitting structure 3 further comprises an electron injection layer 35 and/or electron transport layer 34 arranged between the light emitting layer 31 and the cathode 2, wherein, when the electron transport layer 34 and the electron injection layer 35 exist simultaneously, the electron injection layer 35 will be disposed between the electron transport layer 34 and the cathode 2.

Referring to Figs. 2 and 3, Fig. 2 shows the structure of an organic electroluminescent device according to one example of the invention, which includes an anode 1, a cathode 2 opposite to the anode 1, a light emitting structure 3 between the anode 1 and the cathode 2, and an the insulating layer 4 disposed between the anode 1 and the light emitting structure 3 and adhering to the anode 1, and the light emitting structure 3 comprises a light emitting layer 31, a hole transport layer 32 arranged between the light emitting layer 31 and the insulating layer 4 and an electron transport layer 34 disposed between the light emitting layer 31 and the cathode 2.

Fig. 3 shows the structure of an organic electroluminescent device according to another example of the invention, which includes an anode 1, a cathode 2 opposite to the anode 1, a light emitting structure 3 between the anode 1 and the cathode 2 and an insulating layer 4 arranged between the anode 1 and the light emitting structure 3 and adhering to the anode 1, and the light emitting structure 3 includes a light emitting layer 31, a hole transport layer 32 disposed between the light emitting layer 31 and the insulating layer 4, a hole injection layer 33 arranged between the hole transport layer 32 and the insulating layer 4, an electron transport layer 34 disposed between the light emitting layer 31 and the cathode 2, and an electron injection layer 35 arranged between the electron transport layer 34 and the cathode 2.

The organic electroluminescent device could also have other similar structures, and not limited to the above-described embodiments.

In particular, the anode is a conductive substrate, i.e., a conductive glass, such as indium tin oxide (ITO) glass, fluorine-doped tin oxide (FTO) glass, aluminum-doped zinc oxide (AZO) glass or indium-doped zinc oxide (IZO) glass. The insulating layer is attached onto the anode, and the material thereof is a lithium salt compound. The Li⁺ at the interface between the anode and the organic layer of the light emitting structure is inclined to adhere to the surface of the organic layer, thereby the molecules orientate and align to form a bulk dipole moment, so as to generate the phenomenon of vacuum level offset, decrease the work function of the electrode on the contact surface, reduce the injection rate of the holes from the anode to the light emitting structure, suppress the injection number of the holes, such that the recombination probability of holes and electrons in the light emitting structure is increased, thus the luminescent performance of the device is improved. On the other hand, the bulk dipole moment generated by the above lithium ion can also reduce the diffusion of metal ions of the anode to the light emitting structure, thereby good interface characteristic is formed between the electrode and the light emitting structure, so as to delay the aging of the device, and improve the device stability.

In particular, the lithium salt compound refers to a compound containing lithium ion, without special restriction, e.g., a lithium halide such as lithium fluoride (LiF), lithium chloride (LiCl), lithium bromide, lithium iodide; a lithium oxysalt compound, i.e. the compound consists of a lithium and an oxyacid radical, such as lithium carbonate (Li₂CO₃), lithium oxalate, lithium nitrate, lithium sulfate, lithium sulfite, lithium nitrite, lithium titanate, lithium ferrous phosphate, lithium iron phosphate; and a lithium nitride (Li₃N); or a lithium oxide (LiO₂); as well as other organic or inorganic lithium compounds.

The insulating layer has a thickness of 0.5 to 5 nm, preferably 0.7 to 2 nm, and more preferably 0.7 to 1 nm. The thickness of the insulating layer is restricted to be in the range of 0.5 to 5 nm, so as, on one hand, to offer resistance to the hole transport, but on the other hand the hole transport can not be blocked completely.

In particular, the hole injection layer is made of molybdenum trioxide (MoO₃), tungsten trioxide (WO₃) or VOₓ.

The hole transport layer is made of N,N'-bis(3-methylphenyl)-N,N'-diphenyl-4,4'-biphenyl diamine (TPD), N,N'-(1-naphthyl)-N,N'-diphenyl-4,4'-biphenyl diamine (NPB), 1,3,5-triphenyl benzene(TDAPB) or copper phthalocyanine CuPc.

The light emitting layer is made of tetra(t-butyl)perylene (TBP), 4-(dicyanomethylene)-2-butyl-6-(1,1,7,7-tetramethyljulolidyl-9-enyl)-4H-pyran (DCJTB), 9,10-bis(β-naphthylenyl) anthracene (AND), bis(2-methyl-8-hydroxyquinoline)-(4-phenylphenolato) aluminum (BAlQ), 4-(dicyanomethylene)-2-isopropyl-6-(1,1,7,7-tetramethyljulolidyl-9-enyl)-4H-pyran (DCJTI), N,N'-dimethyl quinacridone (DMQA), or tris(8-hydroxyquinoline) aluminum (Alq₃).

The electron transport layer is made of 2-(4-diphenyl)-5-(4-t-butyl)-phenyl-1,3,4-oxadiazole (PBD), tris(8-hydroxyquinoline) aluminum (Alq₃), 2,5-bis (1-naphthyl)-1,3,4-oxadiazole (BND), 1,2,4-triazole derivative (such as TAZ), N-aryl benzimidazole (TPBI) or quinoxaline derivative (TPQ).

The electron injection layer is made of Cs₂CO₃, LiF, CsF, CaF₂, MgF₂ or NaF.

The material of the metal cathode is silver (Ag), aluminum (Al) or gold (Au).

The said hole injection layer, hole transport layer, light emitting layer, electron transport layer, electron injection layer and cathode, are prepared by evaporation or other means such as sputtering, spray plating, chemical vapor deposition, electrochemical means, etc., according to the structure of the organic electroluminescent device to be prepared. For example, when a solar cell device shown in Fig. 2 is to be prepared, an insulating layer is first arranged on the conductive glass (anode), then a hole injection layer is prepared on the insulating layer, and a hole transport layer is prepared on the hole injection layer, and a light emitting layer is prepared on the hole transport layer, and an electron transport layer is prepared on the light emitting layer, an electron injection layer is prepared on the electron transport layer, at last an cathode is prepared on the electron injection layer.

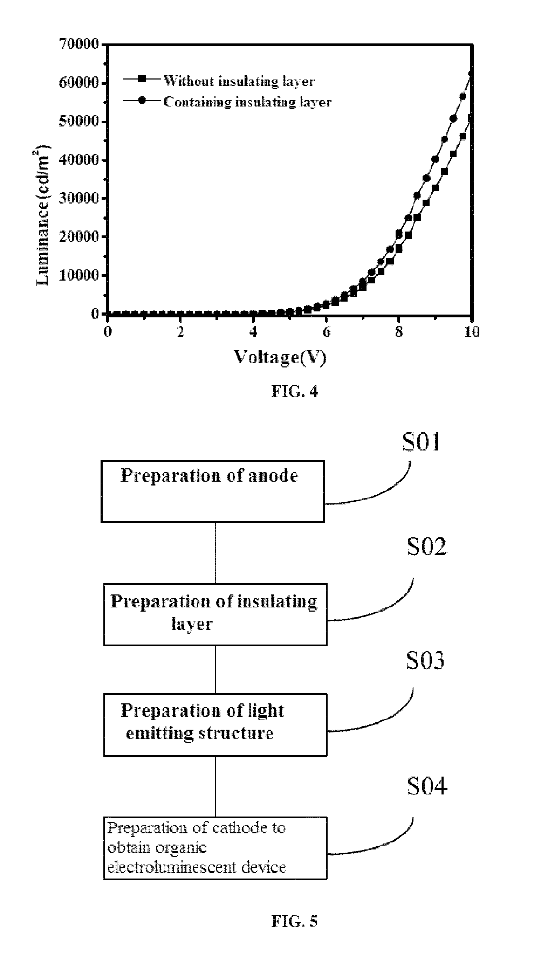

Referring to Fig. 5, which shows a fabrication method of the organic electroluminescent device according to the examples of the present invention, comprising the following steps:

S01, preparation of anode

a conductive substrate is treated by photolithography, after cleaning it is exposed to oxygen plasma or UV-ozone to obtain an anode, wherein the duration of the oxygen plasma treatment is 5-15min, the power thereof is 10-50W; and the duration of the UV-ozone treatment is 5-20min;

S02, preparation of insulating layer

an insulating layer of lithium salt compound is prepared on the anode, the thickness thereof is 0.5-5 nm;

S03, preparation of light emitting structure

a light emitting structure is prepared on the anode;

S04, preparation of cathode to obtain an organic electroluminescent device

a cathode is prepared on the light emitting structure to obtain an organic electroluminescent device.

Furthermore, the fabrication method according to the examples of the present invention further comprises the steps of preparing a hole injection layer, a hole transport layer, an electron transport layer and an electron injection layer. The materials and the preparation methods of the said hole injection layer, the hole transport layer, the electron transport layer and the electron injection layer are the same as those defined above, they will not be detailed again here.

In particular, in step S01, the preparation of anode is the step of treating the conductive substrate: first a conductive substrate is treated by photolithography, then it is trimmed into a desired size, and washed with detergent, deionized water, acetone, ethanol, and isopropyl alcohol sequentially under ultrasonic, each for 15min, to remove the organic contaminants on the surface of the substrate, then the conductive glass is treated by plasma or ozone, e.g. treated by oxygen plasma, or UV-ozone. Wherein the duration of the oxygen plasma treatment is 5-15min, the power thereof is 10-50W; the duration of the UV-ozone treatment was 5-20min. By means of the plasma or ozone treatment, it is possible to reduce the roughness and the wrapping angle of the surface of the conductive substrate, facilitate to improve the wettability and the adsorption of the surface of the conductive substrate, and by means of surface treatment the organic pollutants on the surface of the conductive substrate can be further removed, and the adhesion of the conductive substrate with the organic layer can be impoved, so as to increase the surface work function thereof. The conductive substrate, i.e. the conductive glass, is the same as that defined above, which will not be detailed again here.

In step S02, evaporation or other means such as sputtering, spray plating, chemical vapor deposition, and electrochemical means and the like may be employed, and the vacuum evaporation is preferred. In the process of preparing the insulating layer of lithium salt compound, the formation rate of thickness of the insulating layer is 0.01-0.05nm/s. Wherein the lithium salt compound is the same as that defined above, and it will not be repeated here.

The organic electroluminescent device according to the examples of the invention has an insulating layer prepared on the anode, which hinders the injection rate of the holes from the anode into the light emitting structure, suppresses the number of holes injected into the light emitting structure, ensures the consistency of the number of the holes with that of the electrons in the light emitting structure, greatly improves the recombination probability of holes and electrons, decreases the influence of the excess holes on the luminescent performance of the device.

In particular, the preparation procedure of the light emitting structure in step S02, and the preparation procedure of the cathode in step S03 are the same as those above-mentioned, which will not be repeated here.

The preparation method according to the examples of the present invention is easy to operate, the cost is low, and it is suitable for industrial production.

Different preparation methods according to the present invention will be explained in detail referring to following Examples.

**Example 1**

An ITO glass was treated by photolithography, then trimmed into a desired area for light emitting, and washed with detergent, deionized water, acetone, ethanol, and isopropanol sequentially under ultrasonic, each for 15min, to remove the organic pollutants on the surface of the glass, after the cleaning it was exposed to oxygen plasma at a power of 35W for 5min to give an anode.

An insulating layer of lithium fluoride of 1.0 nm thickness was formed on the anode by vacuum evaporation, the formation rate thereof was 0.02 nm/sec.

A hole injection layer of molybdenum trioxide was formed on the insulating layer of lithium fluoride by evaporation.

A hole transport layer of N, N'-(1-naphthyl)-N, N'-diphenyl-4,4'-biphenyl diamine was formed on the hole injection layer of molybdenum trioxide by evaporation.

A light emitting layer of tris(8-hydroxyquinoline) aluminum was formed on the hole transport layer by evaporation.

An electron transport layer of 2-(4-biphenyl)-5-(4-t-butyl) phenyl-1,3,4-oxadiazol was formed on the light emitting layer by evaporation.

An electron injection layer of CsF was formed on the electron transport layer by evaporation.

A cathode of gold was formed on the electron injection layer by evaporation to obtain an organic electroluminescent device.

**Comparative Example**

In the organic electroluminescent according to the Comparative Example, there is no insulating layer arranged on the anode, and the other aspects of the structure are the same as those of Example 1.

Referring to Fig. 4, which shows the relational graphs of the current density and voltage of the organic electroluminescent devices according to this Example and the Comparative Example respectively. In this figure, when the voltage is 6V, the luminance of the device containing LiF insulating layer is 2773 cd/cm², while the luminance of the ordinary device without an insulating layer is 2263cd/cm². This shows that by adding LiF insulating layer, the injection of holes is partially hindered, and the injection rate of holes is lowered, as a result the hole-electron recombination probability is significantly improved, therefore, the luminance of the device has been increased.

**Example 2**

An ITO glass was treated by photolithography, and washed with detergent, deionized water, acetone, ethanol, and isopropanol sequentially under ultrasonic, each for 15min, then exposed to oxygen plasma at a power of 35W for 5min to obtain an anode.

An LiF insulating layer of 1.5 nm thickness was vacuum spray plated on the anode, wherein the formation rate thereof was 0.01 nm/sec.

A hole injection layer of molybdenum trioxide was formed on the LiF insulating layer by spray plating.

A light emitting layer of tetra(t-butyl)perylene was formed on the hole injection layer by spray plating.

A cathode of silver was formed on the light emitting layer by spray plating to obtain an organic electroluminescent device.

The structure of the organic electroluminescent device and the relationship of the current density and voltage thereof this Example are similar with those of Example 1 respectively, which will not be repeated again.

**Example 3**

An FTO glass was treated by photolithography, and washed with detergent, deionized water, acetone, ethanol, and isopropanol sequentially under ultrasonic, each for 15min, then exposed to UV-ozone at a power of 10W for 15min to obtain an anode.

A lithium nitrate insulating layer of 0.5 nm thickness was formed on the anode by vacuum sputtering, wherein the formation rate thereof was 0.02 nm/sec.

A hole transport layer of N, N'-(1-naphthyl)-N, N'-diphenyl-4,4'-biphenyl diamine was formed on the lithium nitrate insulating layer by sputtering.

A light emitting layer of 9,10-bis(β-naphthylene) anthracene was formed on the hole transport layer by sputtering.

An electron transport layer of tris(8-hydroxyquinoline) aluminum was formed on the light emitting layer by sputtering.

An electron injection layer of LiF was formed on the electron transport layer by sputtering.

A cathode of aluminium was formed on the electron injection layer by sputtering to obtain an organic electroluminescent device.

The structure of the organic electroluminescent device and relationship of the current density and voltage thereof in this Example are similar with those of Example 1 respectively , which will not be repeated again.

**Example 4**

An IZO glass was treated by photolithography, and washed with detergent, deionized water, acetone, ethanol, and isopropanol sequentially under ultrasonic, each for 15min, then exposed to UV-ozone at a power of 50W for 5min to obtain an anode.

A lithium oxalate insulating layer of 10 nm thickness was formed on the anode by vacuum sputtering, wherein the formation rate thereof was 0.05 nm/sec.

A hole transport layer of 1,3,5-triphenyl benzene was formed on the lithium oxalate insulating layer by sputtering.

A light emitting layer of bis(2-methyl-8-hydroxy-quinoline)-(4-phenylphenolato) aluminum was formed on the hole transport layer by sputtering.

An electron injection layer of CsF was formed on the light emitting layer by sputtering.

A cathode of aluminium was formed on the electron injection layer by sputtering to obtain an organic electroluminescent device.

The structure of the organic electroluminescent device and relationship of the current density and voltage thereof in this Example are similar with those of Example 1 respectively , which will not be repeated again.

**Example 5**

An AZO glass was treated by photolithography, and washed with detergent, deionized water, acetone, ethanol, and isopropanol sequentially under ultrasonic, each for 15min, then exposed to UV-ozone at a power of 45W for 6min to obtain an anode.

A lithium titanate insulating layer of 9 nm thickness was formed on the anode by vacuum sputtering, wherein the formation rate thereof was 0.05 nm/sec.

A hole injection layer of tungsten trioxide was formed on the lithium titanate insulating layer by sputtering.

A hole transport layer of copper phthalocyanine was formed on the hole injection layer by sputtering.

A light emitting layer of 4-(dicyanomethylene)-2-isopropyl-6-(1,1,7,7,-tetramethyljulolidyl-9-enyl)-4H-pyran was formed on the hole transport layer by sputtering.

An electron transport layer of N-aryl benzimidazole was formed on the light emitting layer by sputtering.

An electron injection layer of CsF was formed on the electron transport layer by sputtering.

A cathode of aluminium was formed on the electron injection layer by sputtering to obtain an organic electroluminescent device.

The structure of the organic electroluminescent device and relationship of the current density and voltage thereof in this Example are similar with those of Example 1 respectively , which will not be repeated again.

**Example 6**

An IZO glass was treated by photolithography, and washed with detergent, deionized water, acetone, ethanol, and isopropanol sequentially under ultrasonic, each for 15min, then exposed to oxygen plasma at a power of 35W for 8min to obtain an anode.

A lithium titanate insulating layer of 7 nm thickness was formed on the anode by vacuum evaporation, wherein the formation rate thereof was 0.035 nm/sec.

A hole injection layer of tungsten trioxide was formed on the lithium titanate insulating layer by evaporation.

A hole transport layer of copper phthalocyanine was formed on the hole injection layer by evaporation.

A light emitting layer of 4-(dicyanomethylene)-2-isopropyl-6-(1,1,7,7-tetramethyljulolidyl-9-enyl)-4H-pyran was formed on the hole transport layer by evaporation.

An electron transport layer of N-aryl benzimidazole was formed on the light emitting layer by evaporation.

An electron injection layer of CsF was formed on the electron transport layer by evaporation.

A cathode of aluminium was formed on the electron injection layer by sputtering to obtain an organic electroluminescent device.

The structure of the organic electroluminescent device and relationship of the current density and voltage thereof in this Example are similar with those of Example 1 respectively, which will not be repeated again.

**Example 7**

An IZO glass was treated by photolithography, and washed with detergent, deionized water, acetone, ethanol, and isopropanol sequentially under ultrasonic, each for 15min, then exposed to oxygen plasma at a power of 30W for 13min to give an anode.

A lithium titanate insulating layer of 6 nm thickness was formed on the anode by vacuum evaporation, wherein the formation rate thereof was 0.03 nm/sec.

A hole injection layer of tungsten trioxide was formed on the lithium titanate insulating layer by evaporation.

A hole transport layer of copper phthalocyanine was formed on the hole injection layer by evaporation.

A light emitting layer of 4-(dicyanomethylene)-2-isopropyl-6-(1,1,7,7,-tetramethyljulolidyl-9-enyl)-4H-pyran was formed on the hole transport layer by evaporation.

An electron transport layer of N-aryl benzimidazole was formed on the light emitting layer by evaporation.

A cathode of aluminium was formed on the electron transport layer by evaporation to obtain an organic electroluminescent device.

The structure of the organic electroluminescent device and relationship of the current density and voltage thereof in this Example are similar with those of Example 1 respectively , which will not be repeated again.

**Example 8**

An IZO glass was treated by photolithography, and washed with detergent, deionized water, acetone, ethanol, and isopropanol sequentially under ultrasonic, each for 15min, then exposed to oxygen plasma at a power of 25W for 14min to give an anode.

A lithium titanate insulating layer of 5 nm thickness was formed on the anode by vacuum evaporation, wherein the formation rate thereof was 0.025 nm/sec.

A hole injection layer of tungsten trioxide was formed on the lithium titanate insulating layer by evaporation.

A hole transport layer of copper phthalocyanine was formed on the hole injection layer by evaporation.

A light emitting layer of 4-(dicyanomethylene)-2-isopropyl-6-(1,1,7,7,-tetramethyljulolidyl-9-enyl)-4H-pyran was formed on the hole transport layer by evaporation.

An electron transport layer of N-aryl benzimidazole was formed on the light emitting layer by evaporation.

An electron injection layer of CsF was formed on the electron transfer layer by evaporation.

A cathode of aluminium was formed on the electron injection layer by evaporation to obtain an organic electroluminescent device.

The structure of the organic electroluminescent device and the relationship of the current density and voltage thereof in this Example are similar with those of Example 1 respectively , which will not be repeated again.

**Example 9**

An IZO glass was treated by photolithography, and washed with detergent, deionized water, acetone, ethanol, and isopropanol sequentially under ultrasonic, each for 15min, then exposed to oxygen plasma at a power of 20W for 5min to give an anode.

A lithium titanate insulating layer of 4 nm thickness was formed on the anode by vacuum evaporation, wherein the formation rate thereof was 0.02 nm/sec.

A hole injection layer of tungsten trioxide was formed on the lithium titanate insulating layer by evaporation.

A hole transport layer of copper phthalocyanine was formed on the hole injection layer by evaporation.

A light emitting layer of 4-(dicyanomethylene)-2-isopropyl-6-(1,1,7,7,-tetramethyljulolidyl-9-enyl)-4H-pyran was formed on the hole transport layer by evaporation.

An electron transport layer of N-aryl benzimidazole was formed on the light emitting layer by evaporation.

An electron injection layer of CsF was formed on the electron transfer layer by evaporation.

A cathode of aluminium was formed on the electron injection layer by evaporation to obtain an organic electroluminescent device.

The structure of the organic electroluminescent device and the relationship of the current density and voltage thereof in this Example are similar to those of Example 1 respectively, which will not be repeated again.

**Example 10**

An IZO glass was treated by photolithography, and washed with detergent, deionized water, acetone, ethanol, and isopropanol sequentially under ultrasonic, each for 15min, then exposed to oxygen plasma at a power of 15W for 5min to obtain an anode.

A lithium titanate insulating layer of 3 nm thickness was formed on the anode by vacuum evaporation, wherein the formation rate thereof was 0.015 nm/sec.

A hole injection layer of tungsten trioxide was formed on the lithium titanate insulating layer by evaporation.

A hole transport layer of copper phthalocyanine was formed on the hole injection layer by evaporation.

A light emitting layer of 4-(dicyanomethylene)-2-isopropyl-6-(1,1,7,7,-tetramethyljulolidyl-9-enyl)-4H-pyran was formed on the hole transport layer by evaporation.

An electron transport layer of N-aryl benzimidazole was formed on the light emitting layer by evaporation.

An electron injection layer of CsF was formed on the electron transport layer by evaporation.

A cathode of aluminium was formed on the electron injection layer by evaporation to obtain an organic electroluminescent device.

The structure of the organic electroluminescent device and the relationship of the current density and voltage thereof in this Example are similar with those of Example 1 respectively , which will not be repeated again.

**Example 11**

An IZO glass was treated by photolithography, and washed with detergent, deionized water, acetone, ethanol, and isopropanol sequentially under ultrasonic, each for 15min, then exposed to oxygen plasma at a power of 15W for 5min to give an anode.

A insulating layer of lithium carbonate of 0.7 nm thickness was formed on the anode by vacuum evaporation, wherein the formation rate thereof was 0.015 nm/sec.

A hole injection layer of tungsten trioxide was formed on the lithium carbonate insulating layer formed by evaporation.

A hole transport layer of copper phthalocyanine was formed on the hole injection layer by evaporation.

A light emitting layer of 4-(dicyanomethylene)-2-isopropyl-6-(1,1,7,7,-tetramethyljulolidyl-9-enyl)-4H-pyran was formed on the hole transport layer by evaporation.

An electron transport layer of N-aryl benzimidazole was formed on the light emitting layer by evaporation.

An electron injection layer of CaF2 was formed on the electron transport layer by evaporation.

A cathode of aluminium was formed on the electron injection layer by evaporation to obtain an organic electroluminescent device.

The structure of the organic electroluminescent device and relationship of the current density and voltage thereof in this Example are similar with those of Example 1 respectively , which will not be repeated again.

The description above is merely the preferable embodiments of the present invention and not intended to limit the present invention. And all changes, equivalent substitution and improvements which come within the meaning and range of equivalency of the present invention are intended to be embraced therein.

## Claims

1. An organic electroluminescent device, which comprises an anode, a cathode opposite to the anode and a light emitting structure disposed between the anode and the cathode, wherein the organic electroluminescent device further comprises an insulating layer arranged between the anode and the light emitting structure and adhering to the anode, and the insulating layer is made of lithium salt compound and the thickness thereof is 0.5-5nm.

2. The organic electroluminescent device of claim 1, wherein the thickness of the insulating layer is 0.5-2nm.

3. The organic electroluminescent device of claim 1, wherein the thickness of the insulating layer is 0.7-1nm.

4. The organic electroluminescent device of claim 1, wherein the lithium salt compound is selected from the group consisting of lithium halide, lithium oxysalt compound, lithium nitride and lithium oxide.

5. The organic electroluminescent device of claim 4, wherein the lithium halide is selected from the group consisting of lithium fluoride, lithium chloride , lithium bromide and lithium iodide; the lithium oxysalt compound is selected from the group consisting of lithium carbonate, lithium oxalate, lithium nitrate, lithium sulfate, lithium sulfite, lithium nitrite, lithium titanate, lithium ferrous phosphate and lithium iron phosphate.

6. The organic electroluminescent device of claim 1, wherein the the light emitting structure comprises a light emitting layer, a hole injection layer and/or hole transport layer arranged between the light emitting layer and the insulating layer.

7. The organic electroluminescent device of claim 6, wherein the light emitting structure further comprises an electron injection layer and/or electron transport layer arranged between the light emitting layer and the cathode.

8. A method for fabricating the organic electroluminescent device of any of claims 1-7, comprising the following steps:
a conductive substrate is treated by photolithography, after cleaning the conductive substrate is exposed to oxygen plasma or UV-ozone to give an anode, wherein the duration of the oxygen plasma treatment is 5-15min, the power thereof is 10-50W;
and the duration of the UV-ozone treatment is 5-20min;
an insulating layer of lithium salt compound is prepared on the anode, and the thickness thereof is 0.5-5 nm;
a light emitting structure is prepared on the anode;
a cathode is prepared on the light emitting structure to give an organic electroluminescent device.

9. The method of claim 8, wherein in the step of preparing the insulating layer of lithium salt compound, the formation rate of the insulating layer is 0.01-0.05nm/s.

10. The method of claim 8, wherein the material of the anode is selected from the group consisting of indium tin oxide glass, fluorine-doped tin oxide glass, aluminum-doped zinc oxide glass and indium-doped zinc oxide glass.
